# EUROPEAN PATENT APPLICATION

(11) **EP 4 746 652 A1**
(43) Date of publication of application: **20.05.2026**
(21) Application number: 24840156.4
(22) Date of filing: 10.07.2024
(51) Int. Cl.: H10K 30/88, H10K 30/15, H10K 85/50, H10K 30/82, H10K 30/57, H10K 30/85, H10K 30/86, H10K 71/12, H10F 10/17, H10F 77/12

(54) **PEROVSKITE TANDEM SOLAR CELL**

(30) Priority: 10.07.2023 KR 20230089297
(71) Applicant: Hanwha Solutions Corporation, Seoul 04541 (KR)
(72) Inventor: YOUK, Seung Hyun, Seoul 04541 (KR)
(74) Representative: Mooser, Sebastian Thomas
(86) International application number: PCT/KR2024/095898
(87) International publication number: WO 2025/014346

(57) **Abstract**

The present invention provides a perovskite tandem solar cell including an upper cell including a perovskite layer and a lower cell including a silicon layer, wherein an organic planarization layer is interposed between the upper cell and the lower cell to confine particles therein.

## Description

### [Technical Field]

The present invention relates to a perovskite tandem solar cell. More specifically, the present invention relates to a perovskite tandem solar cell including a protective layer.

### [Background Art]

A solar cell can convert sunlight into electrical energy using semiconductor characteristics. Methods of manufacturing a solar cell can be generally classified as a crystalline or thin-film type method, and the crystalline type method is predominantly used. The crystalline type solar cell has an advantage of high photovoltaic conversion efficiency but has disadvantages, such as the high cost of a polysilicon raw material and limited installation sites.

90% or more of the global market share is occupied by crystalline silicon solar cells, and the crystalline silicon solar cell has a low threshold due to thermalization loss of photons with much higher energy than the bandgap and transmission loss of photons with lower energy than the bandgap.

The crystalline silicon solar cell is a representative single-junction solar cell, and the Shockley-Queisser theoretical efficiency limit is about 33%, and the theoretical efficiency of the silicon solar cell considering physical analysis such as Auger recombination, bandgap narrowing, free carrier absorption, or the like is about 29.5%. Since the silicon solar cell has approached the theoretical limit, multi-junction solar cells, that is, tandem solar cells, which can use a solar spectrum more efficiently, have attracted attention.

The tandem solar cell is formed as a single solar cell by connecting single-junction solar cells including absorption layers with different bandgaps. Specifically, a 2-terminal (2T) tandem solar cell is driven as a single solar cell by electrically connecting upper and lower cells in series, and due to such a configuration, is referred to as a monolithic tandem solar cell. The 2T tandem solar cell has an advantage that the upper cell is directly stacked on the lower cell, thereby allowing operation without additional electrical connections during driving of a device. Unlike a 4T tandem solar cell, the 2T solar cell requires a recombination layer because the upper and lower cells are connected in series.

Meanwhile, during a silicon cell manufacturing process, particle generation issues are not considered in a production line, and thus no facilities or countermeasures for particle reduction, such as dust collection or vertical laminar flow formation, are provided in the manufacturing facilities. Particles generated in deposition chambers typically do not affect the efficiency of silicon cells and thus are not considered much.

However, when the recombination layer is formed in the 2T tandem solar cell, an inorganic thin-film material is used to have a nanometer-scale thickness, and when particles are present on a silicon cell below the recombination layer, the particles can cause various defects.

Accordingly, there is an urgent need to develop tandem solar cells of which defects caused by particles are prevented during silicon formation and stability is enhanced.

Korean Laid-Open Patent No. 10-2019-0129370 discloses a tandem solar cell and a method of manufacturing the same as the background technology of the present invention but does not disclose a structure for preventing defects in a recombination layer or a hole transport layer caused by particles on a lower silicon cell.

### [Detailed Description of Invention]

### [Technical Problem]

The present invention is directed to providing a perovskite tandem solar cell including an organic planarization layer for preventing defects in a recombination layer or a hole transport layer caused by particles on a lower cell in the perovskite tandem solar cell. The tandem solar cell provided with the organic planarization layer can maintain the electrical characteristics of a lower cell thin film, thereby preventing a decrease in cell efficiency and significantly improving the production yield of the solar cells.

The present invention is also directed to providing a solar cell, in which a planarization film having transparent conductivity is disposed so that light transmittance is improved, and a recombination layer or a hole transport layer is prevented from being contaminated by particles on a silicon cell so that photovoltaic conversion efficiency is enhanced and durability is improved.

The present invention is also directed to providing a method of manufacturing a perovskite tandem solar cell provided with an organic planarization layer.

The objects and other objects of the present invention can be achieved by the present invention to be described below.

### [Technical Solution]

1. An aspect of the present invention relates to a perovskite tandem solar cell.
   A perovskite tandem solar cell includes an upper cell including a perovskite layer and a lower cell including a silicon layer, wherein an organic planarization layer is interposed between the upper cell and the lower cell, and the organic planarization layer confines particles therein.
2. The organic planarization layer according to No. 1 may be moisture-resistant and cover entire edge regions of the lower cell and the upper cell.
3. The perovskite tandem solar cell according to No. 1 or 2 may have a 2-terminal structure or a 4-terminal structure.
4. Another aspect of the present invention relates to a perovskite tandem solar cell in which a recombination layer is protected.
   A perovskite tandem solar cell includes a silicon layer, an organic planarization layer provided on the silicon layer, a recombination layer provided on the organic planarization layer, a hole transport layer provided on the recombination layer, a perovskite layer provided on the hole transport layer, and an electron transport layer provided on the perovskite layer, wherein the organic planarization layer confines particles of the silicon layer to prevent contamination of the recombination layer and the hole transport layer.
5. The organic planarization layer according to No. 4 may include one of an acrylic-based resin, an epoxy-based resin, and a mixture thereof and include inorganic particles.
6. The inorganic particles according to No. 5 may include one of a silica-based material, a siloxane-based material, and a mixture thereof.
7. The particle according to Nos. 4 to 6 may be a single silicon (Si) particle or a silicon oxide (SiOₓ) particle.
8. The organic planarization layer according to Nos. 4 to 7 may have a thickness of 10 µm or more.
9. The organic planarization layer according to Nos. 4 to 8 may transmit 90% or more of light having a wavelength of about 380 to about 780 nm, have a surface resistance of about 10³ to about 10⁶ Ω/sq., and have a pencil hardness of about 3 H to about 5 H.
10. Each of the recombination layer and the hole transport layer according to Nos. 4 to 9 may have a thickness of about 10 nm to about 100 nm.
11. Still another aspect of the present invention relates to a perovskite tandem solar cell including a transparent conductive organic planarization layer.
   A perovskite tandem solar cell includes a silicon layer, a conductive organic planarization layer provided on the silicon layer, a hole transport layer provided on the conductive organic planarization layer, a perovskite layer provided on the hole transport layer, and an electron transport layer provided on the perovskite layer, wherein the conductive organic planarization layer confines particles of the silicon layer to prevent contamination of the hole transport layer.
12. The conductive organic planarization layer according to No. 11 may include one or more of indium tin oxide (ITO) particles, aluminum-doped ZnO particles, carbon nano tubes (CNTs), and graphene.
13. The conductive organic planarization layer according to No. 11 or 12 may transmit about 80% or more of light having a wavelength of about 380 to about 780 nm, have a resistivity of about 10⁻³ to 10⁻⁵ Ω.cm, and have a pencil hardness of about 2 H to about 3 H.
14. Yet another aspect of the present invention relates to a method of manufacturing a perovskite tandem solar cell including an organic planarization layer.
   A method of manufacturing a perovskite tandem solar cell includes manufacturing an upper cell including a perovskite layer provided with a hole transport layer and an electron transport layer and preparing a lower cell including a silicon layer, coating the silicon layer with a composition for an organic planarization layer, and bonding the upper cell so that an organic planarization layer is interposed between the upper cell and a lower cell, wherein the organic planarization layer confines particles therein.
15. The composition for the organic planarization layer according to No. 14 may include an acrylic-based synthetic resin, an epoxy-based synthetic resin, or a mixture thereof at about 30 wt% to about 40 wt%, a solvent at about 30 wt% to about 50 wt%, an initiator at about 5 wt% to about 10 wt%, a dispersant at about 1 wt% to about 10 wt%, and an additive at about 1 wt% to about 10 wt%.

### [Advantageous Effects]

In a tandem solar cell according to the present invention, an organic planarization layer is formed between a lower underlying silicon layer and an upper perovskite layer, and thus it is possible to prevent contamination of and damage to a recombination layer and a hole transport layer, thereby enhancing both the efficiency and durability of the 2T tandem solar cell.

The organic planarization film can prevent pinholes and cracks from being formed in a perovskite layer due to particles of the silicon cell and prevent small hillocks or layers from being formed or delaminated by the particles. In addition, since an upper layer is stacked after a substrate is planarized, the manufacturing yield can be improved, and the stable structure of the tandem solar cell can be maintained.

### [Description of Drawings]

FIG. 1 is a schematic view of a perovskite tandem solar cell according to one embodiment of the present invention.
FIG. 2 is a schematic view of a perovskite tandem solar cell according to another embodiment.
FIG. 3 is a plan view of the perovskite tandem solar cell according to FIG. 2.
FIG. 4 is a schematic view of a perovskite tandem solar cell according to still another embodiment of the present invention.
FIG. 5 is a process flowchart of a method of manufacturing a perovskite tandem solar cell according to another aspect of the present invention.
FIG. 6 shows scanning electron microscope-energy dispersive x-ray spectroscopy (SEM-EDXS) photographs of particles on a silicon substrate.
FIG. 7 illustrates the distribution of particles on silicon substrates in Comparative Example 1 and Comparative Example 3.
FIG. 8 is a schematic view illustrating physical changes of a subsequent layer caused by particles formed on the silicon substrate.

### [Modes of the Invention]

Hereinafter, the present invention will be described in more detail with reference to the accompanying drawings. However, the following drawings are provided only to help the understanding of the present invention, and the present invention is not limited by the following drawings. In addition, since shapes, sizes, ratios, angles, numbers, and the like disclosed in the drawings are illustrative, the present invention is not limited to the illustrated items.

The same reference number denotes the same components throughout the specification. In addition, in describing the present invention, when it is determined that the detailed description of a related known technology may unnecessarily obscure the gist of the present invention, detailed description thereof will be omitted.

When terms "comprise," "have," "consist of," and the like described in the specification are used, other parts may be added unless "only" is used. When a component is expressed in a singular form, it includes a case in which the component is provided as a plurality of components unless specifically stated otherwise.

In construing a component, the component is construed as including a margin of error even when there is no separate explicit description.

In the present specification, the term "a to b" indicating a numerical range is defined as "≥a and ≤b."

Hereinafter, specific embodiments of the present invention will be described with reference to the accompanying drawings.

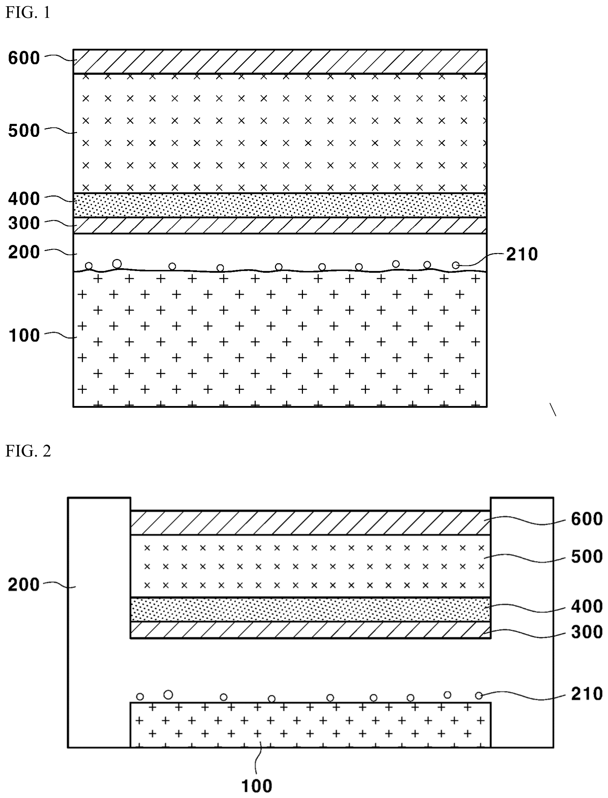

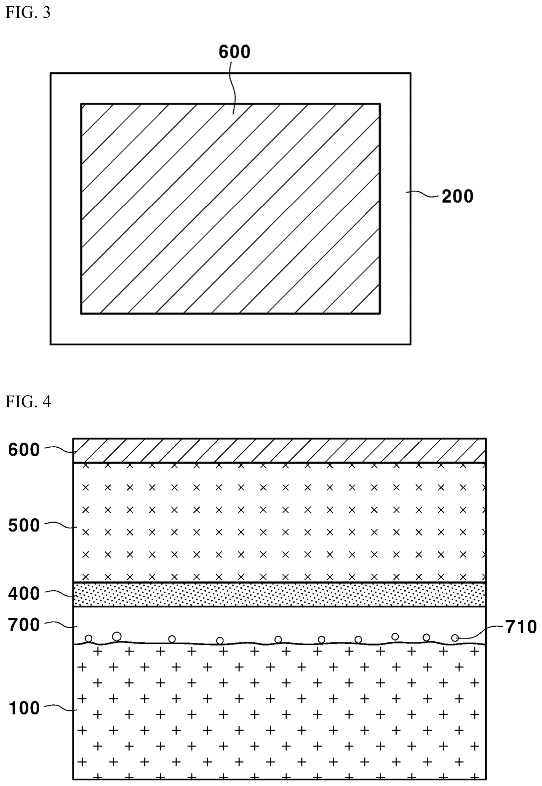

FIG. 1 is a schematic view of a perovskite tandem solar cell according to one embodiment of the present invention, FIG. 2 is a schematic view of a perovskite tandem solar cell according to another embodiment, and FIG. 3 is a plan view of the perovskite tandem solar cell according to FIG. 2.

Referring to FIGS. 1 to 3, a perovskite tandem solar cell includes an upper cell and a lower cell.

The upper cell may include a perovskite layer 500, a hole transport layer 400, and an electron transport layer 600, and electrodes may be formed on the hole transport layer 400 and the electron transport layer 600.

When the perovskite tandem solar cell has a 2-terminal structure, the upper cell may further include a recombination layer 300.

The upper cell includes the perovskite layer 500, and the perovskite layer 500 may be formed as a light-absorbing layer and denoted as ABX₃. Here, A denotes a monovalent organic ammonium cation or metal cation, B denotes a divalent metal cation, and X denotes a halogen anion.

The perovskite layer 500 may be formed by performing coating with a perovskite compound, such as CH₃NH₃PbI₃, CH₃NH₃PbIₓCl₃₋ₓ, MAPbI₃, CH₃NH₃PbIₓBr₃₋ₓ, CH₃NH₃PbClₓBr₃₋ₓ, HC(NH₂)₂PbI₃, HC(NH₂)₂PbIₓCl₃₋ₓ, HC(NH₂)₂PbIₓBr₃₋ₓ, HC(NH₂)₂PbClxBr₃₋ₓ, (CH₃NH₃)(HC(NH₂)₂)_{1-y}PbI₃, (CH₃NH₃)(HC(NH₂)₂)_{1-y}PbIₓCl₃₋ₓ, (CH₃NH₃)(HC(NH₂)₂)_{1-y}PbIₓBr₃₋ₓ, (CH₃NH₃)(HC(NH₂)₂)_{1-y}PbClₓBr₃₋ₓ, and etc., but is not particularly limited as long as a photoactive layer may be formed with a perovskite structure.

The lower cell includes a silicon layer 100.

The silicon layer 100 may be manufactured based on a silicon wafer and manufactured in a manufacturing facility that does not have facilities for reducing particles 210, such as dust collection treatment and vertical laminar flow formation, and the movement of the particles 210 generated from the silicon layer 100 may cause defects in the recombination layer 300 and the hole transport layer 400 disposed above the silicon layer 100.

In one specific example, the organic planarization layer 200 may be interposed between the upper cell and the lower cell to confine particles 210 therein.

The organic planarization layer 200 may be provided to restrict the movement of the particles 210 generated from the silicon layer 100, and by confining the particles 210 within the organic planarization layer 200, degradation of electrical characteristics between the upper and lower cells can be prevented, thereby improving the production yield of the cells.

Referring to FIGS. 2 and 3, in a specific example, the organic planarization layer 200 is moisture-resistant and may cover the entire edge regions of the lower and upper cells.

Since the organic planarization layer 200 is moisture-resistant, moisture can be prevented from penetrating the cells, and by forming the organic planarization layer 200 with a predetermined thickness to cover the edge regions of the lower and upper cells, damage to and contamination of the entire perovskite tandem solar cell can also be prevented.

In a specific example, the perovskite tandem solar cell may have a 2-terminal structure or a 4-terminal structure.

Specifically, when the organic planarization layer 200 is conductive, the perovskite tandem solar cell may have a 2-terminal structure, and when the organic planarization layer 200 is not conductive, the perovskite tandem solar cell may have a 4-terminal structure.

In the 2-terminal structure, since the lower and upper cells are connected in series, the recombination layer 300 having a tunnel junction may be provided above the lower cell, thereby enabling photocurrent matching between the upper and lower cells.

In the 4-terminal structure, terminals on which electrodes are disposed may be formed on each of the lower and upper cells to allow the lower and upper cells to be driven individually, thereby controlling an operating rate and power generation of the solar cell.

In a specific example, the perovskite tandem solar cell is a heterojunction solar cell including the silicon layer 100 and the perovskite layer 500, and when the silicon layer 100 is formed, multiple particles 210 may be formed according to a manufacturing environment, but because the organic planarization layer 200 is provided between the upper and lower cells to confine the particles 210 therein, the stacking reliability of the upper and lower cells is improved, defects of the cell can be prevented, and the manufacturing yield of the cells is improved.

Another aspect of the present invention relates to a perovskite tandem solar cell in which the recombination layer 300 is protected.

The perovskite tandem solar cell includes the silicon layer 100, the organic planarization layer 200, the recombination layer 300, the hole transport layer 400, the perovskite layer 500, and the electron transport layer 600.

The silicon layer 100 may be a conductive semiconductor layer formed on a silicon substrate. Specifically, conductive semiconductor layers having different energy bandgaps may be provided on one surface and the other surface of the silicon substrate to form a p-n junction. Specifically, the silicon layer 100 may have a lower bandgap than the perovskite layer 500 and absorb light in a long wavelength band.

During the manufacturing process, a plurality of particles 210 may be formed on a surface of the silicon layer 100. Specifically, the particles 210 may be formed on the surface of the silicon layer 100 due to the absence of a dust collection device, a vertical laminar flow formation device, or the like for reducing foreign substances in a deposition chamber during manufacturing.

In a specific example, the particle 210 may be a single silicon (Si) particle or a silicon oxide (SiOₓ) particle. When the particle 210 is a single silicon particle or a silicon oxide particle, an average particle size may reach several micrometers (µm), thereby degrading the properties of the subsequent layer formed above the silicon layer 100, and in particular, when the nano-thick recombination layer 300 and hole transport layer 400 are formed, the recombination layer 300 and the hole transport layer 400 may be undergo physical changes and be damaged .

The organic planarization layer 200 is provided on the silicon layer 100.

The organic planarization layer 200 confines the particles 210 of the silicon layer 100, thereby preventing contamination of the recombination layer 300 and the hole transport layer 400.

The organic planarization layer 200 may confine the particles 210 therein, and because the organic planarization layer 200 is provided, the particles 210 are effectively prevented from being introduced into the recombination layer 300 and the hole transport layer 400 to form pinholes or cracks, or hillocks or layers are prevented from being formed or delaminated by compressive stress applied to the recombination layer 300 and the hole transport layer 400.

The organic planarization layer 200 may be formed of an acrylic-based resin, an epoxy-based resin, or a mixture thereof and include inorganic particles.

By including the above type of synthetic resin, the organic planarization layer 200 may be bonded onto the silicon layer 100 and maintain strong bonding strength. When the above type of synthetic resin is used, the synthetic resin is moisture-resistant, and thus edge portions of not only the silicon layer 100, but also the organic planarization layer 200, the recombination layer 300, the hole transport layer 400, the perovskite layer 500, and the electron transport layer 600 can be easily be covered to allow the entire layers of the solar cell to be encapsulated, thereby improving the durability of the solar cell.

The organic planarization layer 200 may allow long-wavelength light to transmit to the silicon layer 100.

In a specific example, the inorganic particles may include one of a silica-based material, a siloxane-based material, and a mixture thereof.

By including the above type of inorganic particles, light entering the organic planarization layer 200 may be scattered, and the efficiency of the solar cell can be enhanced.

In a specific example, the inorganic particles may be conductive, and in this case, a 2-terminal tandem solar cell may be formed.

A thickness of the organic planarization layer 200 is about 10 µm or more, and preferably, may range from about 10 µm to about 100 µm (e.g., 10, 20, 30, 40, 50, 60, 70, 80, 90, or 100 µm).

When the thickness of the organic planarization layer 200 is formed within the above range, the particles 210 may be covered and confined therein, stress can be mitigated, and thus the silicon layer 100 and the surface thereof can be uniformly formed, and surface roughness can be maintained uniformly. When the thickness exceeds the above range, the insulation properties may be increased, thereby interfering with electron movement.

In a specific example, the organic planarization layer 200 may transmit at least 90% (e.g., 90, 91, 92, 93, 94, 95, 96, 97, 98, 99, or 100%) of light having a wavelength of about 380 to about 780 nm (e.g., 380, 390, 400, 410, 420, 430, 440, 450, 460, 470, 480, 490, 500, 510, 520, 530, 540, 550, 560, 570, 580, 590, 600, 610, 620, 630, 640, 650, 660, 670, 680, 690, 700, 710, 720, 730, 740, 750, 760, 770 or 780 nm), have a surface resistance of about 10³ to about 10⁶ Ω/sq. (e.g., 10⁴, 10⁵, or 10⁶ Q/sq.), and have a pencil hardness of about 3 H to about 5 H (e.g., 3, 3.1, 3.2, 3.3, 3.4, 3.5, 3.6, 3.7, 3.8, 3.9, 4, 4.1, 4.2, 4.3, 4.4, 4.5, 4.6, 4.7, 4.8, 4.9, or 5 H).

The organic planarization layer 200 may transmit the light in the above wavelength band, enabling the silicon layer 100 to absorb light energy with high efficiency.

The organic planarization layer 200 may have a resistivity within the above range, and thus maintain high electrical properties, and may exhibit a pencil hardness within the above range and thus may be firmly bonded on the silicon layer 100 without deformation during a subsequent layer bonding process, thereby achieving the effects of the present invention.

The recombination layer 300 is provided on the organic planarization layer 200.

The recombination layer 300 is an electro-optical connection structure that enables tunnel recombination bonding, which connects the upper and lower cells of the tandem solar cell. Specifically, the recombination layer 300 may be formed of indium tin oxide (ITO) or indium gallium zinc oxide (IGZO).

The recombination layer 300 may have a thickness of about 10 nm to about 100 nm (e.g., 10, 20, 30, 40, 50, 60, 70, 80, 90, or 100 nm).

When the recombination layer 300 is formed within the above range, the recombination layer 300 is affected by the particles 210 of the silicon layer 100, and when the particles 210 are introduced into the recombination layer 300, electrical characteristics can be degraded, and thus the recombination layer 300 formed within the above range requires a protective film. The organic planarization layer 200 may be provided together with the recombination layer 300 formed within the above range, thereby eliminating the influence of the particles 210.

The hole transport layer (HTL) 400 is provided on the recombination layer 300. The hole transport layer 400 may transport holes. The hole transport layer 400 may also be provided on the perovskite layer 500.

The hole transport layer 400 may be disposed according to the typical structure of the perovskite solar cell.

The hole transport layer 400 may be formed of an organic material, such as spiro-OMeTAD, or a polymer material. Specifically, the hole transport layer 400 may include an inorganic or organic hole transport material, and the hole transport material may include one or more selected from NiOₓ, CuSCN, CuCrO₂, and CuI.

The hole transport layer 400 may have a thickness of about 10 nm to about 100 nm (e.g., 10, 20, 30, 40, 50, 60, 70, 80, 90, or 100 nm).

When the thickness of the hole transport layer 400 is within the above range and the particles 210 are introduced in the same manner as in the recombination layer 300, electrical characteristics are physically changed and damaged, thereby reducing not only the yield of the solar cell, but also reducing photovoltaic conversion efficiency, and thus the hole transport layer 400 also needs a protective film within the above thickness range. In this case, the organic planarization layer 200 may be provided, thereby eliminating the influence of the particles 210 on the hole transport layer 400.

The perovskite layer 500 is provided on the hole transport layer 400.

The perovskite layer 500 may be formed by performing coating with a perovskite compound and may be a light-absorbing layer that absorbs short-wavelength light.

The perovskite layer 500 may be a single layer formed of the same perovskite material or a multilayered structure in which multiple layers formed of different perovskite materials are stacked, and a different perovskite material from one type of perovskite material having a pillar shape, such as a columnar shape, a plate shape, a needle shape, a wire shape, a rod shape, or the like may be included in the light-absorbing layer formed of the one type of perovskite material.

The electron transport layer 600 is provided on the perovskite layer 500. The electron transport layer 600 may also be provided below the perovskite layer 500.

The electron transport layer 600 can easily transport electrons generated in the perovskite layer 500 to an electrode provided thereon.

The electron transport layer 600 may include a metal oxide, such as oxides of Ti, Zn, In, Sn, W, Nb, Mo, Mg, Zr, Sr, Yr, La, V, Al, Y, Sc, Sm, Ga, SrTi, or a mixture thereof. Specifically, the electron transport layer 600 may preferably include TiO₂ having a compact structure and include SnO₂, WO₃, and TiSrO₃.

The perovskite tandem solar cell according to the present invention, which is a 2-terminal tandem solar cell including the recombination layer 300, may be formed such that the organic planarization layer 200 is provided as a protective film not only to prevent the recombination layer 300 and the hole transport layer 400 from being affected by the particles 210 of the silicon layer 100, thereby improving the manufacturing yield of the solar cell, but also to prevent damage due to physical changes of each layer, thereby improving the durability of the solar cell and enhancing photovoltaic conversion efficiency.

Still another aspect of the present invention relates to a perovskite tandem solar cell including the transparent conductive organic planarization layer 200.

FIG. 4 is a schematic view of a perovskite tandem solar cell according to still another embodiment of the present invention.

Referring to FIG. 4, the perovskite tandem solar cell includes the silicon layer 100, a conductive organic planarization layer 700, the hole transport layer 400, the perovskite layer 500, and the electron transport layer 600.

The conductive organic planarization layer 200 is disposed on the silicon layer 100, the hole transport layer 400 is formed on the conductive organic planarization layer 700, the perovskite layer 500 is formed on the hole transport layer 400, and the electron transport layer 600 is formed on the perovskite layer 500.

Since the configuration of the silicon layer 100, the hole transport layer 400, the perovskite layer 500, and the electron transport layer 600 is the same as that of the above perovskite tandem solar cell, the overlapping descriptions thereof will be omitted.

The conductive organic planarization layer 700 confines particles 710 of the silicon layer 100, thereby preventing contamination of the hole transport layer 400.

The conductive organic planarization layer 200 may include one or more of ITO particles, aluminum-doped ZnO particles, carbon nano tubes (CNTs), and graphene.

By including the above type of conductive particles, the electrical properties of the conductive organic planarization layer 700 can be improved.

The conductive organic planarization layer 700 may transmit at least about 80% (e.g., 80, 81, 82, 83, 84, 85, 86, 87, 88, 89, 90, 91, 92, 93, 94, 95, 96, 97, 98, 99, or 100%) of light having a wavelength of about 380 to about 780 nm (e.g., 380, 390, 400, 410, 420, 430, 440, 450, 460, 470, 480, 490, 500, 510, 520, 530, 540, 550, 560, 570, 580, 590, 600, 610, 620, 630, 640, 650, 660, 670, 680, 690, 700, 710, 720, 730, 740, 750, 760, 770, or 780 nm), have a resistivity of about 10⁻³ to about 10⁻⁵ Ω.cm (e.g., 10⁻³, 10⁻⁴, or 10⁻⁵ Ω.cm), and have a pencil hardness of about 2 H to about 3 H (e.g., 2, 2.1, 2.2, 2.3, 2.4, 2.5, 2.6, 2.7, 2.8, 2.9, or 3 H).

In the perovskite tandem solar cell, the conductive organic planarization layer 700 may transmit the light within the above range, enabling high efficiency absorption of light energy from the silicon layer 100 and maintaining high electrical characteristics. In addition, the conductive organic planarization layer 700 exhibits the pencil hardness within the above range and thus is firmly bonded on the silicon layer 100 and is not deformed during the subsequent layer deposition process.

In a specific example, the conductive organic planarization layer 700 may be formed to a thickness of about 10 µm or more (e.g., 10, 20, 30, 40, 50, 60, 70, 80, 90, or 100 µm), with a thickness variation of about 10% or less (e.g., 1, 2, 3, 4, 5, 6, 7, 8, 9, or 10%). Within the above range, the particles 710 may be sufficiently confined, and a subsequent layer may be easily formed.

According to another aspect of the present invention, a perovskite tandem solar cell including the conductive organic planarization layer 200 may include the conductive organic planarization layer 700, thereby preventing physical deformation of and damage to the recombination layer 300 and the hole transport layer 400 caused by the particles 710 generated from the silicon layer 100, improving electrical characteristics, and significantly enhancing the efficiency of the solar cell.

Still another aspect of the present invention relates to a method of manufacturing a perovskite tandem solar cell including the organic planarization layer 200.

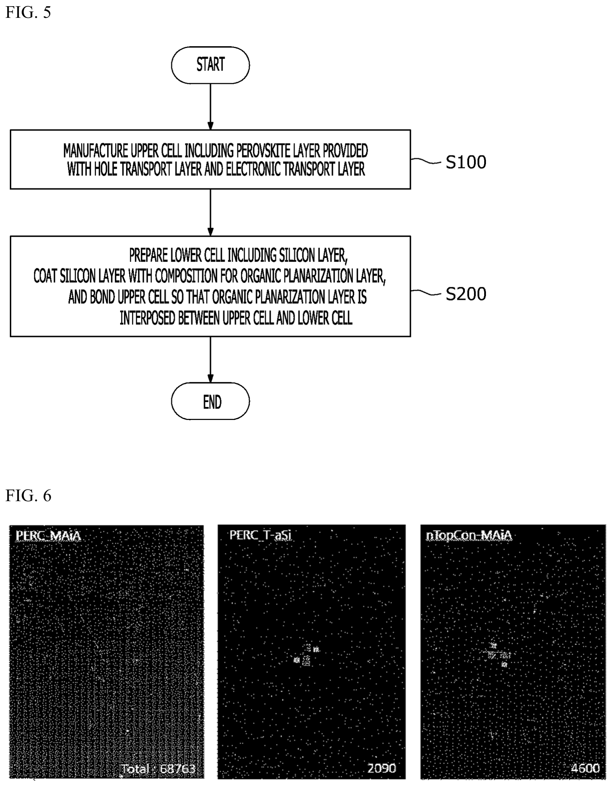

FIG. 5 is a process flowchart of a method of manufacturing a perovskite tandem solar cell according to another aspect of the present invention.

Referring to FIG. 5, the method of manufacturing a perovskite tandem solar cell includes manufacturing the upper cell including the hole transport layer 400, the perovskite layer 500, and the electron transport layer 600, preparing a lower cell including the silicon layer 100, coating the silicon layer 100 with a composition for the organic planarization layer 200, and bonding the upper cell so that the organic planarization layer 200 is interposed between the upper cell and the lower cell.

First, the upper cell including the perovskite layer 500 provided with the hole transport layer 400 and the electron transport layer 600 is manufactured (S100).

In a specific example, the upper cell may include the recombination layer 300. When the perovskite tandem solar cell has a 2-terminal structure, the lower cell and the upper cell are connected in series, and thus the recombination layer 300 having a tunnel junction may be provided on the lower cell.

Thereafter, the lower cell including the silicon layer 100 is prepared, the silicon layer 100 is coated with the composition for the organic planarization layer 200, and the upper cell is bonded so that the organic planarization layer 200 is interposed between the upper cell and the lower cell (S200).

The organic planarization layer 200 may be interposed between the upper cell and the lower cell and cured, and a predetermined level of strength thereof is maintained, thereby maintaining the physical structure of the solar cell, improving durability, and enhancing the efficiency of the solar cell.

In a specific example, the composition for the organic planarization layer 200 may include an acrylic-based synthetic resin, an epoxy-based synthetic resin, or a mixture thereof at about 30 wt% to about 40 wt% (e.g., 30, 31, 32, 33, 34, 35, 36, 37, 38, 39, or 40 wt%), a solvent at about 30 wt% to about 50 wt% (e.g., 30, 31, 32, 33, 34, 35, 36, 37, 38, 39, 40, 41, 42, 43, 44, 45, 46, 47, 48, 49, or 50 wt%), an initiator at about 5 wt% to about 10 wt% (e.g., 5, 6, 7, 8, 9, or 10 wt%), a dispersant at about 1 wt% to about 10 wt% (e.g., 1, 2, 3, 4, 5, 6, 7, 8, 9, or 10 wt%), and an additive at about 1 wt% to about 10 wt% (e.g., 1, 2, 3, 4, 5, 6, 7, 8, 9, or 10 wt%).

Specifically, the solvent may be one or more of propylene glycol monomethyl ether acetate (PGMEA), propylene glycol methyl ether (PGME), and ethyl lactate (ETHYL LACTATE).

The initiator is preferably one or more of 2,2-dimethoxy2-phenylacetophenone (DMPA), 2-isopropyl thioxanthone (2-ITX), and N-methyl diethanol amine (MDEA).

The above type of composition may be formulated within the above range so that its viscosity may be adjusted to about 100 to about 1,000 cP, and the lower cell can be uniformly coated with the transparent organic planarization layer 200 to have a thickness of about 5 µm to about 100 µm with a thickness variation within about 10%, thereby confining the particles 210 to prevent the movement to the upper cell.

The composition within the above range may be cured to exhibit a high pencil hardness of about 3H to about 5H and maintain an elastic modulus of about 0.5 to about 10 GPa.

The organic planarization layer 200 may be coated by a coating method such as spin coating, slot die coating, ink jet coating, blade coating, bar coating, spray coating, gravure coating, or the like, and is not particularly limited as long as on a method may coat an upper portion of the lower cell with the composition, in addition to a sol-gel method.

A method of manufacturing a perovskite tandem solar cell according to another aspect of the present invention includes preparing a composition for the organic planarization layer 200 and performing coating with the composition to form the organic planarization layer 200 with a uniform thickness. The organic planarization layer 200 may confine the particles 210 therein and is transparent, thereby exhibiting high light transmittance, excellent electrical properties, and significantly improving the production yield of the solar cells by providing high surface hardness.

Hereinafter, various exemplary examples are presented to help the understanding of the present invention, but the following examples are merely illustrative of the present invention, and the scope of the present invention is not limited to the following examples.

### Example 1

A hole transport layer was formed by depositing a PEDOT:PSS solution containing NiO on a plastic substrate, a perovskite layer was formed by coating an upper portion of the hole transport layer with a CH₃NH₃PbI₃ perovskite compound, an electron transport layer was formed by coating an upper portion of the perovskite layer with spiro-OMeTAD containing NiO, the substrate was removed, and a recombination layer was bonded by depositing a lower portion of the substrate with an ITO to have a thickness of 100 nm.

A silicon layer was manufactured by forming a photoactive layer on a silicon substrate and bonding electrodes. A composition for an organic planarization layer was prepared with a composition of an epoxy synthetic resin at 30 wt%, propylene glycol monomethyl ether acetate (PGMEA) at 40 wt%, 2,2-dimethoxy-2-phenylacetophenone at 10 wt%, a dispersant at 10 wt%, and an additive at 10 wt%, an upper portion of the silicon layer was spin-coated with the composition, and an upper cell was bonded so that an organic planarization layer was interposed between the upper cell and a lower cell.

The organic planarization layer was irradiated with 500 to 3,000 mJ/cm² of energy using a UV-curable Hg lamp, cured, and heat-treated at 100 to 250 °C, thereby manufacturing a perovskite tandem solar cell.

### Example 2

A perovskite tandem solar cell was manufactured by the same method as in Example 1, but a conductive organic planarization layer was formed by further adding 1 part by weight of ITO nanoparticles as a conductive material to 100 parts by weight of the composition for the organic planarization layer without forming the ITO recombination layer.

### Comparative Examples 1 to 3

Tandem solar cells were manufactured by preparing, as silicon substrates of lower cells, solar cell silicon substrates, PERC MAiA (Comparative Example 1), PERC T-aSi (Comparative Example 2), and nTopCon-mAiA (Comparative Example 3) and bonding an upper cell including a perovskite layer without additionally forming an organic planarization layer.

### Physical properties of organic planarization layer

To determine whether the organic planarization layer of Example 1 affects the efficiency of the solar cell, after the plastic substrate was coated with the composition for the organic planarization layer to have a thickness of 0.1 mm and cured, physical properties were evaluated. According to the measurement using a spectrophotometer, the organic planarization layer had a refractive index of 1.47 to 1.58, a transmittance of 90% or more in a visible light wavelength band (380 to 780 nm), a light absorption rate of 0.1 to 0.5% which maintains transparency, and a surface resistance of 10³ to 10⁶ Ω/sq. It was found that the organic planarization layer was transparent and exhibited excellent electrical properties, thereby enhancing the efficiency of the solar cell.

As a result of evaluating mechanical properties, it was found that the specific gravity ranged from 1 to 1.5, the pencil hardness of the surface was 5 H, and the elastic modulus ranged from 0.5 to 10 GPa, thereby forming a very robust layer to maintain the structural stability of the solar cell.

For the conductive organic planarization layer of Example 2, as a result of evaluating thin film characteristics, it was found that a transmittance was 80% or more in the visible light wavelength band (380 nm to 780 nm), thereby maintaining high transmittance, the resistivity was measured to be 10⁻³ to 10⁻⁵ Q.cm, thereby improving electrical properties, and the pencil hardness was measured to be 2 H to 3 H, thereby bonding the conductive organic planarization layer on the silicon layer while maintaining a robust structure.

### Particle analysis

FIG. 6 shows scanning electron microscope-energy dispersive x-ray spectroscopy (SEM-EDXS) photographs of particles on a silicon substrate.

Referring to FIG. 6, for a silicon substrate used in conventional tandem solar cells, it was found that a large number of particles were formed on the surface, and in particular, in Comparative Example 1 shown in the left image, the number of silicon-based particles accounted for 97% or more of the total number of particles per unit area, and during the manufacturing of the silicon substrate, when no separate particle removal device, such as a dust collection device or a vertical laminar flow formation in the deposition chamber, was present, a large number of particles were formed.

On the other hand, for Examples 1 and 2, since particles were confined within the organic planarization layer, no physical change or damage occurred in the recombination layer or the hole transport layer.

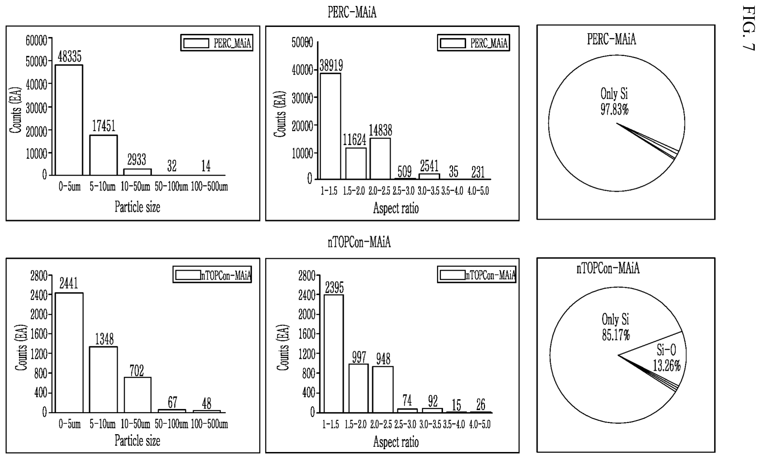

FIG. 7 illustrates the distribution of particles on silicon substrates in Comparative Example 1 and Comparative Example 3.

Referring to FIG. 7, it was found that particles less than 5 µm were the most numerous in the silicon layer, indicating that a large number of particles were formed during the polysilicon formation process. Accordingly, it was found that the thickness of the organic planarization layer was preferably 10 µm or more to sufficiently confine the particles.

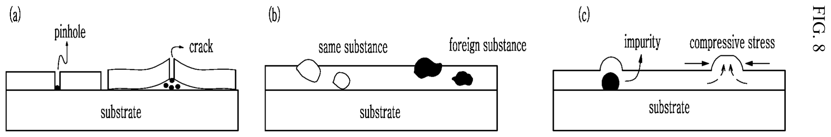

FIG. 8 is a schematic view illustrating physical changes of a subsequent layer caused by particles formed on the silicon substrate.

Referring to FIG. 8, compared to the examples, it was found in the comparative examples that pinholes and cracks caused by environmental particles were in the subsequent layer were generated, resulting in a decrease in tensile strength (see FIG. 8A), defects occurred in the stacked films due to impurities within the chamber or impurities from facility parts, such as contamination on shields or walls within the deposition chamber (see FIG. 8B), and particles within the stacked films induced compressive stress, potentially leading to hillocks or delamination (see FIG. 8C). It was found that the cracks or pinholes in the stacked film served as paths for moisture penetration from the atmosphere due to these defects, thereby reducing the long-term reliability of the panel, and leakage currents were generated by contact between the upper and lower electrodes, resulting in a decrease in shunt resistance and an increase in series resistance.

Accordingly, in the perovskite tandem solar cell according to the present invention, when the protective layer is disposed by adjusting the material and thickness of the organic planarization layer interposed between the upper and lower cells, the organic planarization layer can effectively confine particles, thereby preventing physical changes of or damage to the subsequent films on the silicon layer, thereby improving the durability of the solar cell, enhancing photovoltaic conversion efficiency, and significantly improving the production yield of the tandem solar cells.

So far, various embodiments of the present invention have been mainly described. Those skilled in the art to which the present invention pertains will understand that the present invention may be implemented in a modified form without departing from the essential characteristics of the present invention. Accordingly, the disclosed embodiments should be considered in an illustrative rather than a limiting sense. The scope of the present invention is described in the claims rather than the above description, and all differences in the equivalent scope should be construed as being included in the present invention.

## Claims

1. A perovskite tandem solar cell comprising:
an upper cell including a perovskite layer; and
a lower cell including a silicon layer,
wherein an organic planarization layer is interposed between the upper cell and the lower cell, and
the organic planarization layer confines particles therein.

2. The perovskite tandem solar cell of claim 1, wherein the organic planarization layer is moisture-resistant and covers entire edge regions of the lower cell and the upper cell.

3. The perovskite tandem solar cell of claim 1, which has a 2-terminal structure or a 4-terminal structure.

4. A perovskite tandem solar cell comprising:
a silicon layer;
an organic planarization layer provided on the silicon layer;
a recombination layer provided on the organic planarization layer;
a hole transport layer provided on the recombination layer;
a perovskite layer provided on the hole transport layer; and
an electron transport layer provided on the perovskite layer,
wherein the organic planarization layer confines particles of the silicon layer to prevent contamination of the recombination layer and the hole transport layer.

5. The perovskite tandem solar cell of claim 4, wherein the organic planarization layer includes one of an acrylic-based resin, an epoxy-based resin, and a mixture thereof and further includes inorganic particles.

6. The perovskite tandem solar cell of claims 5, wherein the inorganic particles include one of a silica-based material, a siloxane-based material, and a mixture thereof.

7. The perovskite tandem solar cell of any one of claims 4, wherein the particle is a single silicon (Si) particle or a silicon oxide (SiOₓ) particle.

8. The perovskite tandem solar cell of any one of claims 4, wherein the organic planarization layer has a thickness of 10 µm or more.

9. The perovskite tandem solar cell of any one of claims 4, wherein the organic planarization layer transmits 90% or more of light having a wavelength of about 380 to about 780 nm, has a surface resistance of about 10³ to about 10⁶ Q/sq., and has a pencil hardness of about 3 H to about 5 H.

10. The perovskite tandem solar cell of any one of claims 4, wherein each of the recombination layer and the hole transport layer has a thickness of about 10 nm to about 100 nm.

11. A perovskite tandem solar cell comprising:
a silicon layer;
a conductive organic planarization layer provided on the silicon layer;
a hole transport layer provided on the conductive organic planarization layer;
a perovskite layer provided on the hole transport layer; and
an electron transport layer provided on the perovskite layer,
wherein the conductive organic planarization layer confines particles of the silicon layer to prevent contamination of the hole transport layer.

12. The perovskite tandem solar cell of claim 11, wherein the conductive organic planarization layer includes one or more of indium tin oxide (ITO) particles, aluminum-doped ZnO particles, carbon nano tubes (CNTs), and graphene.

13. The perovskite tandem solar cell of claim 11, wherein the conductive organic planarization layer transmits about 80% or more of light having a wavelength of about 380 to about 780 nm, has a resistivity of about 10⁻³ to 10⁻⁵ Ω.cm, and has a pencil hardness of about 2 H to about 3 H.

14. A method of manufacturing a perovskite tandem solar cell, comprising:
manufacturing an upper cell including a perovskite layer provided with a hole transport layer and an electron transport layer; and
preparing a lower cell including a silicon layer, coating the silicon layer with a composition for an organic planarization layer, and bonding the upper cell so that an organic planarization layer is interposed between the upper cell and the lower cell,
wherein the organic planarization layer confines particles therein.

15. The method of claim 14, wherein the composition for the organic planarization layer includes:
an acrylic-based synthetic resin, an epoxy-based synthetic resin, or a mixture thereof at about 30 wt% to about 40 wt%;
a solvent at about 30 wt% to about 50 wt%;
an initiator at about 5 wt% to about 10 wt%;
a dispersant at about 1 wt% to about 10 wt%; and
an additive at about 1 wt% to about 10 wt%.
